# EUROPÄISCHE PATENTSCHRIFT

(11) **EP 1 527 214 B1**
(45) Veröffentlichungstag und Bekanntmachung des Hinweises auf die Patenterteilung: **18.05.2011**
(21) Anmeldenummer: 03790808.4
(22) Anmeldetag: 23.07.2003
(51) Int. Cl.: C25D 1/10

(54) **VERFAHREN ZUR HERSTELLUNG VON METALL- ODER KERAMIK-MIKROBAUTEILEN**
METHOD FOR PRODUCING METAL OR CERAMIC MICROCOMPONENTS
PROCEDE POUR LA PRODUCTION DE MICROCOMPOSANTS METALLIQUES OU CERAMIQUES

(30) Priorität: 10.08.2002 DE 10236812
(43) Veröffentlichungstag der Anmeldung: 04.05.2005
(73) Patentinhaber: Karlsruher Institut für Technologie, 76131 Karlsruhe (DE)
(72) Erfinder: FINNAH, Guido, 70190 Stuttgart (DE); HAUSSELT, Jürgen, 76726 Germersheim (DE); HOLSTEIN, Nils, 76132 Karlsruhe (DE); JOHANN, Thomas, 76773 Kuhardt (DE); PIOTTER, Volker, 76351 Linkenheim (DE); RUPRECHT, Robert, 75045 Walzbachtal (DE); SCHANZ, Gerhard, 76344 Eggenstein-Leopoldshafen (DE)
(74) Vertreter: Gärtner, Stephan
(86) Internationale Anmeldenummer: PCT/EP2003/008026
(87) Internationale Veröffentlichungsnummer: WO 2004/020703

(56) Entgegenhaltungen:
- DE-A- 10 106 135
- DE-C- 3 537 483
- DE-C- 19 652 966

## Beschreibung

Die Erfindung betrifft ein Verfahren zur Herstellung von Metall- oder Keramik-Mikrobauteilen gemäß des ersten Patentanspruchs.

Ein Weg zur Herstellung von Metall- oder Keramik-Mikrobauteilen umfasst eine Herstellung eines Polymer-Formkörpers als Negativform mit einer zumindest teilweise elektrisch leitenden Oberfläche. In einem weiteren Schritt erfolgt die galvanische Abformung des Metall-Mikrobauteiles auf diesem Polymer-Formkörper über eine galvanische Abscheidung eines Metalls aus einem Elektrolyten oder des Keramik-Mikrobauteils durch elektrophoretische Abscheidung einer Keramik aus einer keramischen Suspension oder Kolloid beginnend auf der als Elektrode dienenden elektrisch leitenden Oberfläche. Dieser Schritt wird auch Galvanoformung oder Elektrophorese genannt. Im Anschluss daran werden Formkörper und Metall- oder Keramik-Mikrobauteil vorzugsweise durch Auflösen des Polymer-Formkörpers in einem Lösungsmittel voneinander getrennt. Ein hierfür eingesetzter Formkörper wird daher auch als verlorene Form bezeichnet.

Für eine qualitativ hochwertige und reproduzierbare Herstellung von Metall- oder Keramik-Mikrobauteils über eine vorgenannte galvanische oder elektrophoretische Abformung ist die Vermeidung von Einschlüssen, Lunkern oder anderen Materialinhomogenitäten von immanenter Bedeutung. Die galvanische oder elektrophoretische Abscheidungsrate steigt nämlich mit er Feldliniendichte. Weisen beispielsweise mehrere abstehende Strukturen, welche auf dem Formkörper nahe beieinander angeordnet sind, eine elektrische leitende Oberfläche auf, kommt es an diesen zu einer bevorzugten galvanischen oder elektrophoretischen Abscheidung, im ungünstigen Fall zu einem Überdecken der Bereiche zwischen den Strukturen und damit zu einem Abschneiden dieser Bereiche vom laufenden Prozess. Meist wachsen in diesen Bereichen unerwünschte Lunker oder Einschlüsse aus Resten des verwendeten Elektrolyten oder Suspension bzw. Kolloides ein.

Zur Vermeidung derartiger Effekte ist es erforderlich, die elektrisch leitende Oberfläche und damit die galvanische oder elektrophoretische Abscheidung eines Metalls oder einer Keramik auf bestimmte Bereiche des Formkörpers zu beschränken. Abstehende, elektrisch nichtleitende Strukturen, aufgesetzt auf einer elektrisch leitenden Oberfläche auf einem Substrat, bewirken beispielsweise eine Abscheidung des Metalls oder der Keramik selektiv und mit konstanter Abscheidungsrate auf der Substratoberfläche und nach einer gewissen Zeit ein allmähliches und fehlerfreies Überdecken der Strukturen durch das abgeschiedene Metall.

In [1] sind mehrere Verfahrensansätze für die Herstellung von Metall-Mikrobauteilen durch Galvanoformung in verlorenen Kunststoffformen beschrieben. Als Alternativen für die Herstellung der verlorenen Formen werden das Spritzgießen, Warmumformen sowie das Reaktionsgießen erläutert. Im Rahmen des Spritzgießens wird eine elektrisch leitende Oberfläche als Metallschicht mit einem Sputterverfahren auf den fertigen Formkörper aufgebracht, wobei senkrecht stehende Strukturflächen verfahrensbedingt geringere Schichtdicken mit einem höheren elektrischen Widerstand aufweisen. Beim Warmumformungsverfahren werden dagegen besputterte Kunststoffflächen durch Warmumformung, d.h. Prägen, strukturiert, wobei die Sputterschicht durch den Stempel mit eingedrückt wird und in den Bereichen der abstehenden Strukturen aufreißt. Als drittes offenbartes Verfahren wird das relativ aufwendige Reaktionsgießen beschrieben, wobei nichtleitende Strukturen aus einem Reaktionsgießharz auf ein elektrisch leitenden Substrat aufgebracht werden.

Entscheidend für die fehlerfreie Herstellung von Metall- oder Keramik-Mikrobauteilen mit der Galvanoformung oder Elektrophorese liegt in der Güte der verlorenen Form. Idealerweise sind die Strukturen elektrische Isolatoren, welche auf einem Substrat mit elektrisch gut leitfähiger Oberfläche aufgebracht sind. Aufgerissene Sputterschichten, wie sie vor allem bei dem zuvor beschriebenen Warmumformungsverfahren auftreten, können lokal Materialinhomogenitäten, Einschlüsse oder Lunker hervorrufen. Das Reaktionsgießverfahren erfüllt zwar die genannten elektrischen Rahmenbedingungen, ist aber in seiner zuverlässigen Umsetzung relativ aufwendig. Zudem ist ein Überdecken des elektrisch leitenden Substrats durch das Reaktionsgießharz zuverlässig zu unterbinden.

Ferner beschreibt [2] eine Vorrichtung zur Erzeugung von Mikrostrukturen aus mehrlagigen Kunststoffschichten mittels eines Zweikomponenten-Spritzgussverfahrens. In [3] wird dieses Spritzgussverfahren für die Herstellung einer Galvanikform vorgeschlagen

Ausgehend davon ist es Aufgabe der Erfindung, ein Verfahren zur Herstellung von Metall- oder Keramik-Mikrobauteilen mit einer Galvanikform vorzuschlagen, das sich insbesondere durch eine verbesserte Trennschärfe zwischen einer elektrisch leitenden und einer elektrisch nichtleitenden Polymerfraktion der Galvanikform auszeichnet.

Diese Aufgabe wird durch die Merkmale in Anspruch 1 gelöst; die hierauf bezogenen Unteransprüche beinhalten vorteilhafte Ausführungsformen dieser Lösung.

Die Erfindung betrifft ein Verfahren zur Herstellung von Metall- oder Keramik-Mikrobauteilen umfassend eine Herstellung eines dreidimensionalen Formkörpers als verlorene Form mit einem Zweikomponenten-Spritzgießverfahren. Die Formkörper umfassen ein Substrat mit einer Substratoberfläche mit von dieser abstehenden Strukturen, wobei die Strukturen aus einer elektrisch nichtleitfähigen Polymerfraktion bestehen und die Substratoberfläche im Bereich um die Strukturen ganz oder zum überwiegenden Teil von einer elektrisch leitfähigen Polymerfraktion abgedeckt ist. Die Unterschritte umfassen die Herstellung eines Zwischenformkörpers aus einer der beiden Polymerfraktionen mit einem Spritzgießprozess in eine erste evakuierte Kavität eines mehrteiligen Spritzgießwerkzeugs. Es folgt ein Austausch mindestens eines Teils des Spritzgießwerkzeuges durch mindestens ein anderes Teil des Spritzgießwerkzeugs, wobei der Zwischenformkörper in den verbleibenden Teilen des Spritzgießwerkzeugs verbleibt und mit den verbleibenden und den anderen Teilen des Spritzgießwerkzeuges mindestens eine zweite Kavität bildet. Es folgt als dritter Unterschritt ein zweiter Spritzgießprozess, und zwar ein Einspritzen einer anderen Polymerfraktion in die zweite Kavität, welche ggf. zuvor evakuiert wird. Ein weiterer Verfahrensschritt beinhaltet die Herstellung des Metall-Mikrobauteils durch galvanische Abscheidung eines Metalls aus einem Elektrolyten oder des Keramik-Mikrobauteils durch elektrophoretische Abscheidung einer Keramik aus einer keramischen Suspension oder Kolloid beginnend auf der als Elektrode dienenden elektrisch leitenden Polymerfraktion auf der Substratoberfläche.

Zweikomponenten-Spritzgießverfahren für die Herstellung von Formkörper sind zwar als solche bekannt, weisen aber Nachteile auf, welche einen Einsatz zur Herstellung von Formkörpern für eine Galvanoformung im Mikromaßstab mit den eingangs erwähnten Eigenschaften ausschließen oder als nicht geeignet erscheinen lassen. Zur Vermeidung möglicher Schwachstellen werden beim Zweikomponenten-Spritzgießverfahren nämlich meist zwei miteinander mischbare Polymere vorzugsweise gleicher Polymerbasis verwendet, welche während des zweiten Spritzgießvorganges an den Materialübergängen miteinander leicht verschmelzen. Hierdurch kommt es zu einer lokalen Durchmischung der Polymerfraktionen, welche insbesondere im Mikrobereich schnell unakzeptable Größen in Relation zu den Abmessung des Formkörpers erreichen. Eine ausreichende Trennschärfe zwischen einer elektrisch leitenden und einer elektrisch nichtleitenden Polymerfraktionen ist somit nicht sicherzustellen.

Es wird daher ein modifiziertes Zweikomponenten-Spritzgießverfahren für die Herstellung des Mikroformkörpers vorgeschlagen, wobei für den zweiten Spritzgießprozesses die hierfür verwendeten Spritzgießwerkzeuge und Formeinsätze mit dem Zwischenformkörper auf eine Temperatur nahe der Schmelztemperatur der anderen der beiden Polymerfraktionen aufgeheizt werden. Dabei weist die im ersten Spritzgießprozess verarbeitete Polymerfraktionen gegenüber der im zweiten Spritzgießprozess verspritzen Polymerfraktion einen höheren Schmelzpunkt auf. Hierdurch wird in besonders vorteilhafter Weise eine Vermischung der Polymerfraktionen miteinander vermieden oder reduziert.

Es wird vorgeschlagen, zwei nicht oder allenfalls unter den vorhandenen Verfahrensbedingungen nur bedingt miteinander lösliche Polymerfraktionen oder Polymerfraktionen mit Schmelzpunktunterschieden miteinander zu verspritzen, wobei es praktisch zu keiner Durchmischung zwischen den Polymerfraktionen kommt. Die mechanische Stabilität des Formkörpers ist somit durch Form- und vorzugsweise Kraftschluss zu realisieren. In jedem Fall ist aber ein dichtender Kontakt der Verbindungen sicherzustellen, ein Eindringen von Elektrolytbestandteile während der Galvanoformung zuverlässig zu unterbinden. Daher hat die im zweiten Spritzgießprozess verarbeitete Polymerfraktion einen höheren thermischen Ausdehnungskoeffizienten und/oder einen höheren Erstarrungsschmelzpunkt aufzuweisen als die erste Polymerfraktion.

Die verwendeten Polymerfraktionen basieren beispielsweise auf den Polymeren Polyethylen (PE), Polyoxymethylen (POM), Polyamid (PA), Polymethylmethacrylat (PMMA), Polyetheretherketon (PEEK), Liquid Crystal Polymer (LCP, flüssigkristalliner Kunststoff) oder einem thermoplastischen Elastomer. Die elektrisch leitenden Polymerfraktion enthält zudem einen elektrisch leitfähigen Füllstoff. Als Vorraussetzung für eine galvanische Abscheidung überhaupt ist ein spezifischer Widerstand kleiner 1000 Ω/cm, für die zuverlässige Erzeugung einer geschlossenen galvanischen Beschichtung über eine flächige Keimbildung ist ein Widerstand kleiner 300 Ω/cm empirisch oder mit Hilfe einer Perkulationsberechnung einzustellen. Als Füllstoff eignen sich grundsätzlich alle elektrisch leitfähigen Materialien, besonders aber kohlenstoffhaltige Pulver wie z.B. Ruß, Leitruß, Graphit oder auch Kohlefasern.

Grundsätzlich ist der Zwischenformkörper entweder aus der elektrisch leitfähigen oder aus der elektrisch nicht leitfähigen Polymerfraktion herstellbar.

Wird der Zwischenkörper aus einer elektrisch leitfähigen Polymerfraktion hergestellt, muss dieser zur Vermeidung einer Abdeckung der elektrisch leitenden Substratoberfläche durch die elektrisch nichtleitende Polymerfraktion während des zweiten Spritzgießprozesses zwischen den hierbei verwendeten Teilen des Spritzgießwerkzeuges oder der Formeinsätze eingespannt werden. Hierdurch wird zudem eine potentielle Beschädigung des Formeinsatzes vermieden. Die elektrisch leitenden Substratoberflächen oder zumindest der überwiegendenden Anteil dieser zumindest im Bereich der abstehenden Strukturen müssen dabei zuverlässig durch die Formeinsätze oder Spritzgießwerkzeuge dichtend abgedeckt werden. Grundsätzlich bietet es sich an, den Anteil der Substratoberfläche, welcher vollständig durch Teile des Spritzgießwerkzeuges abgedeckt ist, als ein Teil einer Klemmfläche zwischen Spritzgießwerkzeug und Zwischenformkörper heranzuziehen.

Die Herstellung von Metall-Mikrobauteilen durch Galvanoformung im Rahmen der Mikrosystemtechnik erfordert meist Formkörper mit einem plattenförmigen Substrat und einseitig abstehenden Mikrostrukturen. Insofern bietet es sich in vorteilhafter Weise an, in einem ersten Spritzgießprozessschritt einen plattenförmigen Zwischenformkörper herzustellen, welcher Durchbrüche aufweist, die im zweiten Spritzgießprozess als Angüsse zu den abstehenden Strukturen dienen. Insofern liegt es auch im Äquivalenzbereich der Erfindung, den Zwischenformkörper nicht im Rahmen des ersten Spritzgießprozesses herzustellen, sondern als fertiges Teil in die Spritzgießwerkzeug oder in den Formeinsatz zu integrieren.

Alternativ erfolgt die Herstellung des Zwischenformkörpers durch den ersten Spritzgießprozess mit der elektrisch nichtleitfähigen Polymerfraktion, wobei die abstehenden Strukturen Teil des Zwischenkörper sind. Dabei bietet es sich an, den Zwischenkörper aus mehreren voneinander trennbaren Zwischenkörperteilen zu konzipieren, wobei die Angüsse gemeinsam mit einem Teil der für den zweiten Spritzgussprozess auszutauschenden Teile des Spritzgießwerkzeuges oder der Formeinsätze entfernbar sind.

Die Erfindung wird anhand der folgenden Verfahrensbeispiele mit Hilfe der folgenden Figuren erläutert. Es zeigen
Fig. 1a bis e schematisch den Ablauf eines Verfahrens zur Herstellung eines Metall-Mikrobauteils gemäß des ersten Verfahrensbeispiels,
Fig. 2a bis c schematisch den Ablauf Teile eines Verfahrens zur Herstellung eines Metall-Mikrobauteils gemäß des zweiten Verfahrensbeispiels, sowie
Fig. 3a bis e Gestaltungsalternativen des Formkörpers im Bereich der abstehenden Strukturen in einer Schnittdarstellung.

### Verfahrensbeispiel 1:

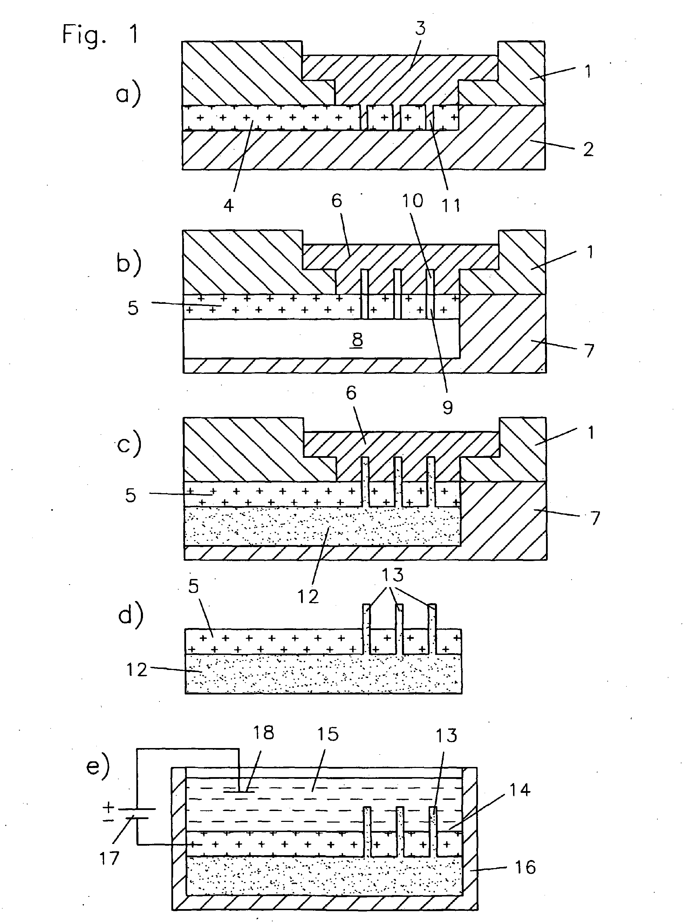

Ein Verfahren zur Herstellung eines Metall-Mikrobauteils gemäß des ersten Verfahrensbeispiels, dargestellt in den Figuren 1a bis e, umfasst eine Herstellung eines Formkörpers als verlorene Form, bei dem der Zwischenkörper aus einem elektrisch leitenden Polymer hergestellt ist.

Dabei zeigt Figur 1 a ein oberes und ein unteres Teil eines Spritzgießwerkzeugs 1 und 2 sowie einen in das obere Teil eingesetzten Formeinsatz 3 für einen ersten Spritzgießprozess. Die Kavität zwischen dem Formeinsatz 3 und dem unteren Teil 2 wird in diesem ersten Spritzgießprozess mit einer Formmasse 4 gefüllt. Als Formmasse 4 dient eine elektrisch leitfähige Polymerfraktion, im vorliegenden Beispiel Polyamid 6.6 gefüllt mit Kohlenstofffasern (Anteil 30%, Durchmesser 5 bis 7 µm, Länge 3 bis 6 mm) als leitfähigem Füllstoff. Bei einem minimalen Durchmesser der erhabenen Strukturen 11 im Formeinsatz 3 von 260µm und einem Aspektverhältnis, d. h. einem Verhältnis der Strukturhöhe zur maximalen Strukturbreite, von 5, wurden für den ersten Spritzgießprozess im vorliegenden Ausführungsbeispiel eine Formmassentemperatur von ca. 280°C und eine Werkzeugtemperatur von ca. 120°C gewählt. Nach dem ersten Spritzgießprozess erkaltet die Formmasse 4 im Formeinsatz 3 und in den Spritzgießwerkzeugen 1 und 2 zu einem Zwischenformkörper 5 (vgl. Fig. 1 b). Die Strukturen auf dem Formeinsatz 3 sind dabei so ausgelegt, dass sie im Zwischenformkörper 5 Durchgangsöffnungen 9 erzeugen.

Fig. 1b zeigt die Umrüstung des Spritzgießwerkzeugs für den zweiten Spritzgießprozess. Dazu wird der Formeinsatz 3 gegen einen zweiten, anderen Formeinsatz 6 mit Mikrokavitäten 10 anstelle der Strukturen sowie der untere Teil 2 des Spritzgießwerkzeugs gegen ein zweites unteres Teil 7 des Spritzgießwerkzeugs unter Bildung einer zweiten Kavität 8 gewechselt. Die Positionierung des zweiten Formeinsatzes 6 über dem Zwischenformkörper 5 erfolgt derart, dass die Durchgangsöffnungen 9 im Zwischenformkörper 5 in die Mikrokavitäten 10 des Formeinsatzes 6 münden, wobei die Mikrokavitäten 10 die Durchgangsöffnungen 9 vollständig überdecken. In diesem Beispiel beträgt der Öffnungsdurchmesser der Mikrokavitäten 300 µm.

Es folgt der zweite Spritzgießprozess gemäß Fig. 1c, d. h. das Einspritzen der zweiten, elektrisch nichtleitenden Polymerfraktion 12 in die zweite Kavität 8, welche die Durchgangsöffnungen 9 und die Mikrokavitäten 10 umfasst. Bei Einsatz von Polyoxymethylen (POM) wird eine Formmassentemperatur von ca. 200°C eingestellt. Die Formmasse fließt von der zweiten Kavität 8 durch die Durchgangsöffnungen 9 im Zwischenformkörper 5 in die Mikrokavitäten 10 des zweiten Formeinsatzes 6. Dazu ist im Fall von POM ein spezifischer Einspritzdruck von ca. 900bar zu wählen. Vorteilhafterweise kommt dabei ein sog. Variotherm-Prozess zur Anwendung, welcher sich durch eine Temperierung von Spritzgießwerkzeug und Formeinsatz, im vorliegenden Fall auf etwa 150°C, auszeichnet, d.h. das Werkzeug wird auf eine Temperatur nahe dem Schmelzbereich der eingespritzten Formmasse erwärmt.

Wesentlich für den zweiten Spritzgießprozess ist, dass der Formeinsatz 6 dichtend auf den Zwischenformkörper 5 aufgesetzt ist. Außerdem ist die Kavität vor dem Einspritzen der zweiten Polymerfraktion zu evakuieren. Dadurch wird vermieden, dass die zweite Polymerfraktion während des zweiten Spritzgießvorganges nicht zwischen Zwischenformkörper 5 und Formeinsatzes 6 eingedrückt wird und in diesem Bereich die elektrisch leitfähige Oberfläche des Zwischenformkörpers 5 elektrisch isolierend abdeckt. Eine elektrisch isolierend abgedeckte elektrisch leitende Fläche würde nämlich für eine anschließende Galvanoformung nicht mehr als Elektrodenfläche bzw. Abscheidungsfläche zur Verfügung stehen.

Zur deformationsfreien Entformung des Formteils, umfassend den elektrisch leitenden Zwischenformkörper 5, die zweite, elektrisch nichtleitenden Polymerfraktion 12 inklusive den nicht leitfähigen abstehenden Strukturen 13 (Fig. 1 d) wird das Werkzeug auf z.B. 90°C heruntergekühlt.

Das Formteil wird im Anschluss daran vorzugsweise ohne weitere Bearbeitung im Bereich der abstehenden Strukturen 13 als verlorene Form der Galvanoformung, bestehend aus einem wässrigen Elektrolyten 15 in einem Becken 16 sowie einer DC-Spannungsversorgung 17 und einer Anode 18, zugeführt (Fig. 1 e). Dabei dient die freie Oberfläche des Zwischenformkörpers 5 im Bereich der abstehenden Strukturen 13 als Substrat 14. Das Substrat dient bei der Galvanoformung als Elektrode (Kathode, d. h. Minuspol), auf dem Metall über eine Reduktion von Metall-Ionen aus einem wässrigen Elektrolyten 15 galvanische abgeschieden wird. Die abstehenden Strukturen 13 aus der elektrisch nichtleitenden Polymerfraktion werden somit in das Metall invertiert, d. h. im Umkehrton kopiert. Hierzu ist eine ausreichende elektrische Oberflächenleitfähigkeit der elektrisch leitenden Kunststofffraktion, d. h. des Zwischenformkörpers 5 bzw. des Substrats 14 sicherzustellen.

### Verfahrensbeispiel 2:

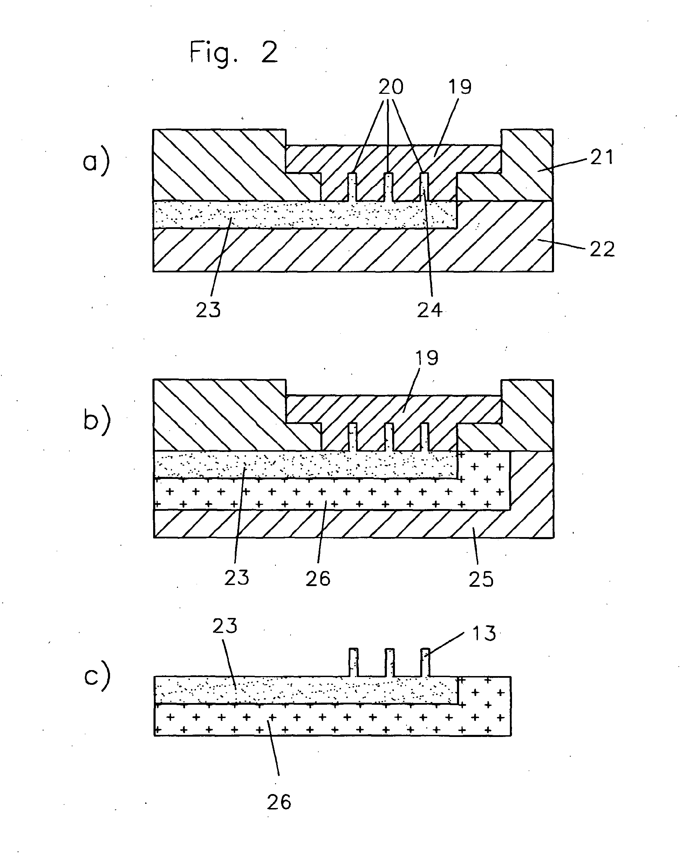

Ein Verfahren zur Herstellung eines Metall-Mikrobauteils gemäß des zweiten Verfahrensbeispiels, dargestellt in den Figuren 2a bis c, umfasst eine Herstellung eines Formkörpers als verlorene Form, bei dem der Zwischenkörper aus einem elektrisch nichtleitenden Polymer hergestellt ist.

Bei diesem Verfahrensbeispiel wird in einem ersten Spritzgießprozess, wie in Fig. 2 a dargestellt, ein Formeinsatz 19 mit eingesenkten Mikrostrukturen 20 sowie einem oberen und einem Spritzgießwerkzeugteil 21 und 22 eine erste Formmasse aus einer elektrisch nichtleitenden Polymerfraktion in eine evakuierte und temperierte erste Kavität eingespritzt, welche in diesen zu einem Zwischenformkörper 23 mit abstehenden Strukturen 24 erstarrt. Formeinsätze und Spritzgießwerkzeuge sind im Verfahrensbeispiel so ausgebildet, dass ein Zwischenformkörper entsteht, welcher aus mehreren parallel zueinander angeordneten kammähnlichen Zwischenformkörperteilen mit zusammenlaufenden Angüssen besteht. Die Angüsse können dabei so gestaltet sein, dass sie nach dem ersten Spritzgießprozess entfernt werden können. Die kammähnlichen Strukturen erstrecken sich zwischen den abstehenden Strukturen auch auf Substratbereiche, wobei die Oberfläche hier lokal von der elektrisch nichtleitenden Polymerfraktion gebildet werden. Während der Galvanoformung wachsen diese ausgehend von den elektrisch leitenden Oberflächebereichen wie die abstehenden Strukturen durch das galvanisch abgeschiedene Metall zu.

Durch Einspritzen einer Formmasse, im vorliegenden Verfahrensbeispiel Polymethylmetacrylat (PMMA), wird die Kavität mit einschließlich den Mikrostrukturen 20 gefüllt. Typische Spritzparameter für PMMA sind eine Formmassentemperatur von 230°C und eine Werkzeugtemperatur beim Einspritzen von ca. 130°C. Der spezifische Einspritzdruck beträgt 850 - 900 bar.

Nach dem Erkalten des Zwischenformkörpers 23 wird der dem Formeinsatz gegenüberliegende untere Spritzgießwerkzeugteil 22 gegen ein zweites unteres Spritzgießwerkzeugteil 25 ausgetauscht. Die dabei entstehende zweite Kavität wird im Rahmen eines zweiten Spritzgießprozesses (Fig. 2 b) mit einer Formmasse aus einer elektrisch leitenden Polymerfraktion 26, z.B. Polyamid 12 (PA 12) mit 15-20% Leitruß, gefüllt. Typische Spritzparameter für Ruß gefülltes PA 12 liegen bei 250°C Formmassetemperatur und 130°C Werkzeugtemperatur. Bei diesem Beispiel braucht für das PA 12 kein Variotherm-Prozess gefahren werden. Jedoch muss die Werkzeugtemperatur auf etwa 90°C gesenkt werden, um eine Entformung des PMMA-Strukturen zu ermöglichen (Variotherm-Prozess). Der spezifische Einspritzdruck beträgt ca. 800 bar. Grundsätzlich sind zur Erzielung eines zufriedenstellendes Spritzgießergebnisses die Kavitäten auch hier wie bei den Spritzgießprozessen des ersten Verahrensbeispiesl zu evakuieren und die Spritzgießwerkzeuge wie die Formeinsätze zu temperieren.

Nach dem Erkalten des PMMA und PA 12 wird das Formteil mit den abstehenden Strukturen, dargestellt in Fig. 2c ohne Formeinsatz und Spritzgießwerkzeug, aus dem Formeinsatz herausgezogen und vorzugsweise ohne Nachbehandlung im Bereich der abstehenden Strukturen einer Galvanoformung, welche im Prinzip anhand des ersten Verfahrensbeispiels (vgl. Fig. 1 e) beschrieben wurde, zugeführt.

Gegenüber des Formkörpers gemäß des ersten wird im zweiten Verfahrensbeispiel im Rahmen des ersten Spritzgießprozesses der Zwischenformkörper gemeinsam mit den abstehenden Strukturen gegossen. Es entfällt auf diese Weise der Wechsel des Formeinsatzes 19 vor dem zweiten Spritzgießprozess und damit eine mögliche Ursache für eine ungewollte Überdeckung der elektrisch leitenden Substrats durch die elektrisch nichtleitenden Polymerfraktion. Dennoch ist es beim zweiten Verfahrensbeispiel von immanenter Bedeutung, ein Eindringen von elektrisch nichtleitenden Polymeranteilen in die Trennfugen zwischen Formeinsatz 19 und unterem Spritzgießwerkzeugteils 22 während des ersten Spritzgießprozess beispielsweise durch ein Anpressen von Formeinsatz und Spritzgießwerkzeug zu unterbinden. Ein derartiges Eindringen würde nämlich von vornherein eine unerwünschte Überdeckung des elektrisch leitenden Substrats durch eine isolierende Beschichtung bewirken.

Beim zweiten Verfahrensbeispiel sollte die elektrisch leitende Polymerfraktion einen höheren thermischen Ausdehnungskoeffizienten als die elektrisch nichtleitende Polymerfraktion aufweisen, damit die im zweiten Spritzgießprozess eingegossenen kammähnlichen Strukturen zusätzlich durch die elektrisch leitfähige Polymerfraktion eingespannt sind. Dies bedeutet eine zusätzliche Sicherung gegen ein ungewolltes Eindringen des wässrigen Elektrolyten zwischen die Grenzfläche zwischen den beiden Polymerfraktionen des Formkörpers bei der Galvanoformung vor allem dann, wenn die beiden Polymerfraktionen keine gegenseitige Löslichkeit aufweisen.

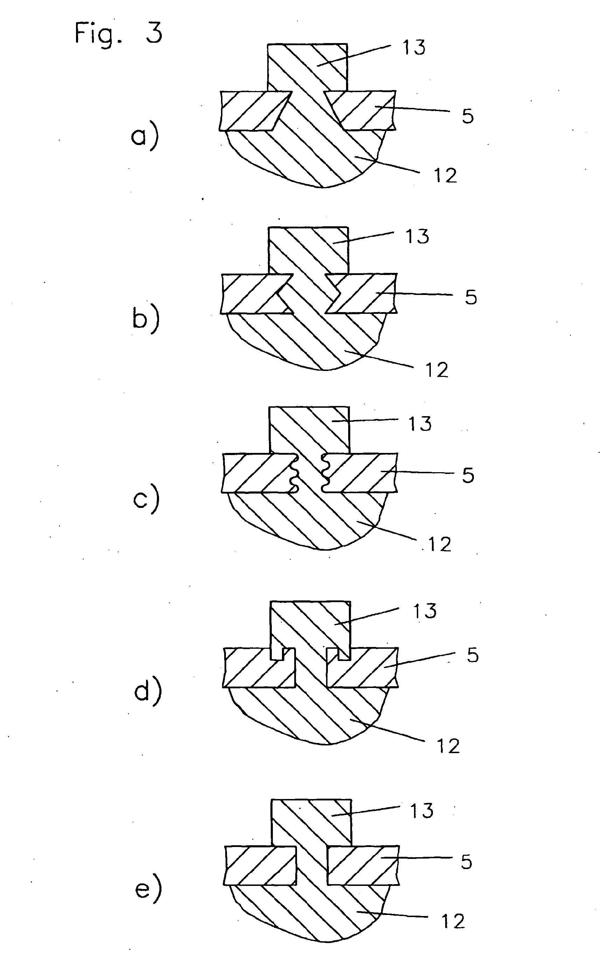

Im ersten Verfahrensbeispiel erstreckt sich die elektrisch nichtleitende Polymerfraktion durch den elektrisch leitenden Zwischenformkörper hindurch zu den abstehenden Strukturen (vgl. Fig. 1 d). Für den Fall, dass die beiden Polymerfraktion nicht miteinander lösbar sind, entsteht hierdurch eine Nietenähnliche Verbundstruktur. Fig. 3a bis e gibt hierzu Gestaltungsalternativen an, wobei sich die dargestellten Bereiche auf eine der abstehenden Strukturen 13 auf dem Zwischenformkörper 5 beschränken. Dargestellt sind eine konische (Fig. 3 a), eine doppelkonische (Fig. 3 b), eine gewellte Verbindung (Fig. 3 c), eine Verbindung mit Widerhaken (Fig.'3 d) sowie eine Verbindung mit rauer Oberfläche (Fig. 3 e). Sinn einer derartigen Gestaltung liegt in der notwendigen Rahmenbedingung, dass bei einer Galvanoformung ein Eindringen des Elektrolyts an den Grenzflächen zwischen den beiden Polymerfraktionen des Formkörpers zuverlässig auszuschließen ist. Eine Wärmeausdehnung der elektrisch nichtleitenden Polymerfraktion gegenüber der des Zwischenformkörpers bewirkt ein Andrücken der abstehenden Strukturen auf den Zwischenformkörper ähnlich eines Zugankers.

### Literatur:

[1] V.Piotter, R.Ruprecht, J.H.Haußelt, J. Schrök: Verfahren zur Herstellung von LIGA-Metallmikrostrukturen durch Galvanoformung in verlorene Kunststoffformen; Jahrbuch Oberflächentechnik, Bd.52 (1996) 33-44
[2] DE 196 52 966 C1
[3] DE 101 06 135 A1

### Bezugszeichenliste

- 1: Oberes Spritzgießwerkzeug
- 2: Unteres Spritzgießwerkzeug
- 3: Formeinsatz
- 4: Formmasse
- 5: Zwischenformkörper
- 6: Zweiter Formeinsatz
- 7: Zweites unteres Spritzgießwerkzeug
- 8: Zweite Kavität
- 9: Durchgangsöffnung
- 10: Mikrokavität
- 11: Erhabene Struktur
- 12: Zweite Polymerfraktion
- 13: Abstehende Struktur
- 14: Substrat
- 15: Elektrolyt
- 16: Becken
- 17: DC-Spannungsversorgung
- 18: Anode
- 19: Formeinsatz
- 20: Mikrostrukturen
- 21: Oberes Spritzgießwerkzeugteil
- 22: Unteres Spritzgießwerkzeugteil
- 23: Zwischenformkörper
- 24: Abstehenden Struktur
- 25: Zweites unteres Spritzgießwerkzeugteil
- 26: Elektrisch leitende Polymerfraktion

## Patentansprüche

1. Verfahren zur Herstellung von Metall- oder Keramik-Mikrobauteilen umfassend folgende Verfahrensschritte:
a) Herstellung eines dreidimensionalen Formkörpers mit einem Zweikomponenten-Spritzgießverfahren, umfassend ein Substrat mit einer Substratoberfläche mit von dieser abstehenden Strukturen, wobei die Strukturen aus einer ersten Polymerfraktion bestehen und die Substratoberfläche im Bereich um die Strukturen zum überwiegenden Teil von einer zweiten Polymerfraktion abgedeckt ist, umfassend
1) Eine Herstellung eines Zwischenformkörpers aus einer der beiden Polymerfraktionen mit einem Spritzgießprozess in eine erste evakuierte Kavität eines mehrteiligen Spritzgießwerkzeugs,
2) Ein Austausch mindestens eines Teils des Spritzgießwerkzeuges durch mindestens ein anderes Teil des Spritzgießwerkzeugs, wobei der Zwischenformkörper in den verbleibenden Teilen des Spritzgießwerkzeugs verbleibt und mit den verbleibenden und den anderen Teilen des Spritzgießwerkzeuges mindestens eine zweite Kavität bildet, sowie
3) Ein Einspritzen der anderen der beiden Polymerfraktionen in die zweite Kavität, welche zuvor evakuiert wird, mit einem zweiten Spritzgießprozess,
wobei
4) die erste Polymerfraktion eine elektrisch nichtleitfähige Polymerfraktion und die zweite Polymerfraktion eine elektrisch leitfähigen Polymerfraktion ist,
b) Herstellung des Metall-Mikrobauteils durch galvanische Abscheidung eines Metalls aus einem Elektrolyten oder des Keramik-Mikrobauteils durch elektrophoretische Abscheidung einer Keramik aus einer keramischen Suspension oder Kolloid beginnend auf der als Elektrode dienenden elektrisch leitenden Polymerfraktion auf der Substratoberfläche, wobei
c) für den zweiten Spritzgießprozess die verbleibenden und die anderen Teile des Spritzgießwerkzeugs mit dem Zwischenformkörper auf eine Temperatur nahe der Schmelztemperatur der anderen der beiden Polymerfraktionen aufgeheizt werden, wobei die für den ersten Spritzgießprozess eine der beiden Polymerfraktionen gegenüber der anderen einen höheren Schmelzpunkt aufweist.

2. Verfahren zur Herstellung von Metall- oder Keramik-Mikrobauteilen nach Anspruch 1, wobei die Herstellung des Zwischenformkörpers durch den ersten Spritzgießprozess mit der elektrisch leitfähigen Polymerfraktion erfolgt.

3. Verfahren zur Herstellung von Metall- oder Keramik-Mikrobauteilen nach Anspruch 2, wobei der Zwischenformkörper während des zweiten Spritzgießprozesses zwischen den anderen und den verbleibenden Teilen des Spritzgießwerkzeuges eingespannt ist, wobei der Zwischenformkörper Oberflächen aufweist, welche den überwiegendenden Anteil der Substratoberfläche im Bereich der abstehenden Strukturen bilden, wobei Teile des Spritzgießwerkzeuges diesen Anteil der Substratoberfläche vollständig abdecken.

4. Verfahren zur Herstellung von Metall- oder Keramik-Mikrobauteilen nach Anspruch 3, wobei der Anteil der Substratoberfläche, welcher vollständig durch Teile des Spritzgießwerkzeuges abgedeckt ist, als ein Teil einer Klemmfläche zwischen spritzgießwerkzeug und Zwischenformkörper fungiert.

5. Verfahren zur Herstellung von Metall- oder Keramik-Mikrobauteilen nach einem der Ansprüche 2 bis 4, wobei der Zwischenformkörper Durchbrüche aufweist, welche bei dem zweiten Spritzgießprozess als Angüsse von der zweiten Kavität zu den abstehenden Strukturen dienen.

6. Verfahren zur Herstellung von Metall- oder Keramik-Mikrobauteilen nach einem der vorangegangenen Ansprüche, wobei die erste Polymerfraktion einen höheren thermischen Ausdehnungskoeffizienten als die zweite Polymerfraktion aufweist.

7. Verfahren zur Herstellung von Metall- oder Keramik-Mikrobauteilen nach Anspruch 1, wobei die Herstellung des Zwischenformkörpers durch den ersten Spritzgießprozess mit der elektrisch nichtleitfähigen Polymerfraktion erfolgt, wobei der zwischenkörper die abstehenden Strukturen umfasst.

8. Verfahren zur Herstellung von Metall- oder Keramik-Mikrobauteilen nach Anspruch 7, wobei der Zwischenkörper aus mehreren voneinander trennbaren Zwischenkörperteilen besteht.

9. Verfahren zur Herstellung von Metall- oder Keramik-Mikrobauteilen nach einem der vorangegangenen Ansprüche 7 und 8, wobei die zweite Polymerfraktion einen höheren thermischen Ausdehnungskoeffizienten als die erste Polymerfraktion aufweist.

10. Verfahren zur Herstellung von Metall- oder Keramik-Mikrobauteilen nach einem der vorangegangenen Ansprüche, wobei die erste und die zweite Polymerfraktion auf den Polymeren Polyethylen (PE), Polyoxymethylen (POM), Polyamid (PA), Polymethylmethacrylat (PMMA), Polyetheretherketon (PEEK), Liquid Crystal Polymer (LCP) oder einem thermoplastischen Elastomer basieren.

11. Verfahren zur Herstellung von Metall- oder Keramik-Mikrobauteilen nach einem der vorangegangenen Ansprüche, wobei die zweite Polymerfraktion einen elektrisch leitfähigen Füllstoff enthält.

12. Verfahren zur Herstellung von Metall- oder Keramik-Mikrobauteilen nach Anspruch 10, wobei der elektrisch leitfähige Füllstoff Ruß, Leitruß, Graphit oder Kohlefasern ist.

## Claims

1. Method for production of metal or ceramic microcomponents, comprising the following method steps:
a) production of a three-dimensional moulded body using a two-component injection moulding process, comprising a substrate with a substrate surface with structures protruding therefrom, wherein the structures comprise a first polymer fraction and the substrate surface in the region of the structures is largely covered by a second polymer fraction, comprising
1) production of an intermediate moulded body from one of the two polymer fractions using an injection moulding process in a first evacuated cavity of a multipiece injection moulding tool,
2) exchange of at least one part of the injection moulding tool for at least one other part of the injection moulding tool, wherein the intermediate moulded body remains in the remaining parts of the injection moulding tool and with the remaining and other parts of the injection moulding tool forms at least one second cavity, and
3) injection of the other of the two polymer fractions into the second cavity which has previously been evacuated, using a second injection moulding process,
wherein
4) the first polymer fraction is an electrically non-conductive polymer fraction and the second polymer fraction is an electrically conductive polymer fraction,
b) production of the metal microcomponent by galvanic deposition of a metal from an electrolyte or of the ceramic microcomponent by electrophoretic deposition of a ceramic from a ceramic suspension or colloid beginning on the electrically conductive polymer fraction serving as electrode on the substrate surface,
wherein
c) for the second injection-moulding process, the remaining and the other parts of the injection moulding tool with the intermediate moulded body are heated to a temperature close to the melt temperature of the other of the two polymer fractions, wherein the one of the two polymer fractions for the first injection-moulding process has a higher melting point than the other.

2. Method for production of metal or ceramic microcomponents according to claim 1, wherein the production of the intermediate moulded body using the first injection moulding process takes place with the electrically conductive polymer fraction.

3. Method for production of metal or ceramic microcomponents according to claim 2, wherein the intermediate moulded body is clamped between the other and the remaining parts of the injection moulding tool during the second injection moulding process, the intermediate moulded body having surfaces which form the majority part of the substrate surface in the region of the protruding structures, wherein parts of the injection moulding tool completely cover this part of the substrate surface.

4. Method for production of metal or ceramic microcomponents according to claim 3, wherein the part of the substrate surface completely covered by parts of the injection moulding tool functions as a part of a clamping surface between the injection moulding tool and the intermediate moulded body.

5. Method for production of metal or ceramic microcomponents according to any of claims 2 to 4, wherein the intermediate moulded body has openings which in the second injection moulding process serve as gates from the second cavity to the protruding structures.

6. Method for production of metal or ceramic microcomponents according to any of the preceding claims, wherein the first polymer fraction has a higher thermal expansion coefficient than the second polymer fraction,

7. Method for production of metal or ceramic microcomponents according to claim 1, wherein the production of the intermediate moulded body by the first injection moulding process takes place with the electrically non-conductive polymer fraction, the intermediate body comprising the protruding structures.

8. Method for production of metal or ceramic microcomponents according to claim 7, wherein the intermediate body comprises several intermediate body parts which can be separated from each other.

9. Method for production of metal or ceramic microcomponents according to any of the preceding claims 7 and 8, wherein the second polymer fraction has a higher thermal expansion coefficient than the first polymer fraction.

10. Method for production of metal or ceramic microcomponents according to any of the preceding claims, wherein the first and second polymer fractions are based on the polymers polyethylene (PE), polyoxymethylene (POM), polyamide (PA), polymethylmethacrylate (PMMA), polyetheretherketone (PEEK), liquid crystal polymer (LCP) or a thermoplastic elastomer.

11. Method for production of metal or ceramic microcomponents according to any of the preceding claims, wherein the second polymer fraction contains an electrically conductive filler.

12. Method for production of metal or ceramic microcomponents according to claim 10, wherein the electrically conductive filler is soot, conductive carbon black, graphite or carbon fibres.

## Revendications

1. Procédé d'obtention de microcomposants métalliques ou céramiques comportant les étapes suivantes :
a) Fabrication par un procédé de moulage par injection à deux composants, d'un corps moulé tridimensionnel comportant un substrat ayant une surface de substrat sur laquelle des structures font saillie, ces structures étant réalisées en une première fraction polymère, et la surface du substrat étant recouverte, dans sa plus grande partie, autour des structures, d'une seconde fraction polymère, comportant :
1) La fabrication d'un corps moulé intermédiaire en une des deux fractions polymères par un premier procédé de moulage par injection, dans une première cavité mise sous vide d'un outil de moulage par injection en plusieurs parties,
2) Le remplacement d'au moins une partie de l'outil de moulage par injection par au moins une autre partie de cet outil, le corps moulé intermédiaire restant dans les parties restantes de l'outil de moulage par injection et délimitant au moins une seconde cavité avec les parties restantes et les autres parties de cet outil, et
3) L'injection de l'autre fraction polymère dans la seconde cavité, préalablement mise sous vide par un second procédé de moulage par injection,
étant précisé que
4) La première fraction polymère est une fraction polymère non électriquement conductrice tandis que la seconde fraction polymère est une fraction polymère électriquement conductrice,
b) Fabrication du microcomposant électronique par dépôt par galvanisation d'un métal à partir d'un électrolyte ou du microcomposant céramique par dépôt par électrophorèse d'une céramique à partir d'un colloïde ou d'une suspension céramique, ce sur la surface du substrat, la fraction polymère électriquement conductrice faisant office d'électrode,
étant précisé que
c) Lors du second procédé de moulage par injection, les parties restantes et les autres parties de l'outil de moulage par injection, ainsi que le corps moulé intermédiaire sont chauffés à une température située à proximité de la température de fusion de l'autre fraction polymère, la fraction polymère utilisée lors du premier procédé de moulage par injection présentant, un point de fusion supérieur à celui de l'autre fraction polymère.

2. Procédé d'obtention de microcomposants métalliques ou céramiques conforme à la revendication 1,
selon lequel
la fabrication du corps moulé intermédiaire par le premier procédé de moulage par injection est réalisée avec la fraction polymère électriquement conductrice.

3. Procédé d'obtention de microcomposants métalliques ou céramiques conforme à la revendication 2,
selon lequel
lors du second procédé de moulage par injection, le corps moulé intermédiaire est bloqué entre les autres parties et les parties restantes de l'outil de moulage par injection, ce corps moulé intermédiaire comportant des surfaces constituant la plus grande partie de la surface du substrat dans la zone des structures en saillie, des parties de l'outil de moulage par injection recouvrant totalement cette partie de la surface du substrat.

4. Procédé d'obtention de microcomposants métalliques ou céramiques conforme à la revendication 3,
selon lequel
la partie de la surface du substrat qui est totalement recouverte par des parties de l'outil de moulage par injection, constitue un élément d'une surface de blocage entre l'outil de moulage par injection et le corps moulé intermédiaire.

5. Procédé d'obtention de microcomposants métalliques ou céramiques conforme à l'une des revendications 2 à 4,
selon lequel
le corps moulé intermédiaire comporte des ouvertures qui lors du second procédé de moulage par injection font office de culot d'injection entre la seconde cavité et les structures en saillie.

6. Procédé d'obtention de microcomposants métalliques ou céramiques conforme à l'une des revendications précédentes,
selon lequel
la première fraction polymère présente un coefficient de dilatation thermique supérieur à celui de la seconde fraction polymère.

7. Procédé d'obtention de microcomposants métalliques ou céramiques conforme à la revendication 1,
selon lequel
la fabrication du corps moulé intermédiaire par le premier procédé de moulage par injection est réalisé avec la fraction polymère non électriquement conductrice, le corps intermédiaire entourant les structures en saillie.

8. Procédé d'obtention de microcomposants métalliques ou céramiques conforme à la revendication 17,
selon lequel
le corps intermédiaire est constitué de plusieurs éléments de corps intermédiaires pouvant être séparés les uns des autres.

9. Procédé d'obtention de microcomposants métalliques ou céramiques conforme à l'une des revendications 7 et 8 précédentes,
selon lequel
la seconde fraction polymère présente un coefficient de dilatation thermique supérieur à celui de la première fraction polymère.

10. Procédé d'obtention de microcomposants métalliques ou céramiques conforme à l'une des revendications précédentes,
selon lequel
la première et la seconde fraction polymère, ont pour base les polymères suivants : polyéthylène (PE), polyoxyméthylène (POM), polyamide (PA), polyméthylméthacrylate (PMMA), polyéthéréthercétone (PEEK), polymères à cristaux liquides (LCP), ou élastomères thermoplastiques.

11. Procédé d'obtention de microcomposants métalliques ou céramiques conforme à l'une des revendications précédentes,
selon lequel
la seconde fraction polymère renferme une charge électriquement conductrice.

12. Procédé d'obtention de microcomposants métalliques ou céramiques conforme à la revendication 10,
selon lequel
la charge électriquement conductrice, est constituée par du noir de carbone, du noir de carbone conducteur, du graphite, ou des fibres de carbone.
